# EUROPEAN PATENT APPLICATION

(11) **EP 1 054 450 A2**
(43) Date of publication of application: **22.11.2000**
(21) Application number: 00110666.5
(22) Date of filing: 18.05.2000
(51) Int. Cl.: H01L 29/10, H01L 29/78

(54) **MOSFET semiconductor device with highly doped barrier region**

(30) Priority: 18.05.1999 JP 13676899
(71) Applicant: Hiroshima University, Higashi-Hiroshima City, Hiroshima Pref. (JP)
(72) Inventor: Miura, Michiko, Higashi-Hiroshima City, Hiroshima Pref. (JP); Tanaka, Masayasu, Higashi-Hiroshima City, Hiroshima Pref. (JP); Mattausch, Hans Jürgen, Higashi-Hiroshima City, Hiroshima Pref. (JP)
(74) Representative: Henkel, Feiler, Hänzel

(57) **Abstract**

In a semiconductor device with MOSFET structure, a source region and a drain region are provided in a surface of a semiconductor substrate having a substantially uniform low impurity concentration such that a channel is formed between the source and drain regions, a gate oxide film is provided on the surface of the semiconductor substrate, a gate region is provided on the gate oxide film, and a highly doped island region is formed at a center of the channel such that the island region extends into the semiconductor substrate up to a level which is substantially identical with the source and drain regions to provide a potential barrier within the channel.

## Description

### Background of the Invention

### Field of the Invention

The invention relates to a semiconductor device, and more particularly relates to a semiconductor device having a so-called MOSFET structure.

### Related Art Statement

In the semiconductor industry, the circuit properties and degree of integration have been improved and a cost down has been attained by miniaturization of semiconductor devices or elements. A Metal-Oxide-Semiconductor-Field-Effect-Transistor (MOSFET) structure has played a leading part in this respect.

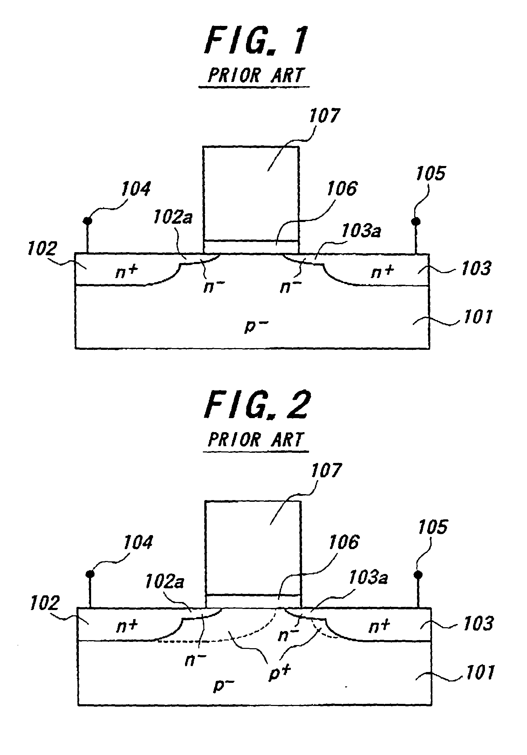

Fig. 1 is a cross sectional view showing a semiconductor device having such a MOSFET structure. A substrate 100 made of silicon is subjected to the impurity diffusion process to have a low impurity concentration such that a channel is formed by a bulk of the substrate. A source junction region 102 and a drain junction region 103 both having a higher impurity concentration are formed in a surface of the substrate 101 by diffusion, and a source electrode 104 and a drain electrode 105 are formed on these source and drain junction regions 102 and 103, respectively. From the source electrode 104 and source junction region 102, carriers are injected into the channel and the thus injected carriers are drawn into the drain junction region 103 and drain electrode 105. In this MOSFET structure, the channel is defined by a lightly doped source and drain regions 102a and 103a.

A gate oxide film 106 is formed on the substrate 101 and a gate portion 107 is formed on the gate oxide film 106 such that a potential distribution within the channel is controlled by a voltage applied to the gate portion. A concentration of carriers observed as an electric current at the drain electrode 105 can be controlled by a distribution and a value of the potential within the channel.

In accordance with a recent progress in the semiconductor device, the MOSFET structure has been miniaturized such that a channel length becomes about 0.1 µm. Then, the device performance could hardly be improved by the miniaturization due to the high electric field effect applied to the channel. Furthermore, it has been difficult to suppress a variation of the device property (especially, threshold voltage) of a number of semiconductor devices formed on a same wafer.

In order to solve the above problems and to improve the device property, there have been proposed various semiconductor devices having special structures.

For example, Hiroki et al proposed in Tech. Digest IEDM, p.439 (1995) a structure, in which a region 108 having a higher impurity concentration is formed within a channel on a side of a source junction region 102 as shown in Fig. 2. In Fig. 2, components similar to those shown in Fig. 1 are denoted by the same reference numerals used in Fig. 1.

However, in this known structure, the highly doped region 108 is formed to be non-symmetrical with respect to the source and drain junction regions 102 and 103, and therefore a possible improvement in the device property by this structure is meaningless to apply this structure to actual circuits.

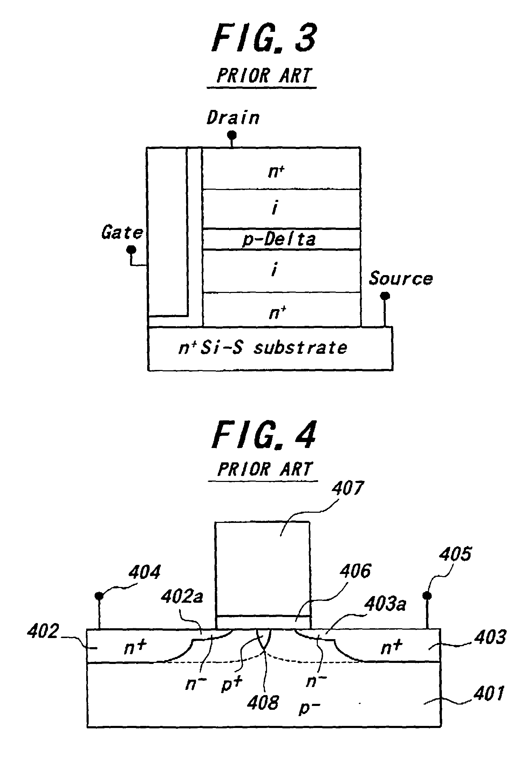

In Tech. Digest IEDM, p.811 (1997), Rao et al. proposed a vertical type MOSFET structure, in which a region p-Delta having a high impurity concentration is provided at a center of a vertical channel formed by intrinsic regions i as shown in Fig. 3. However, in this vertical MOSFET structure, since the control of an electric current by the gate, which is one of important characteristics of the MOSFET structure, could nor be carried out sufficiently, the device property could not be improved effectively.

Y. Momiyama er al proposed, in Tech. Digest Symp. ULSI Tech., p.78 (1998), another MOSFET structure as illustrated in Fig. 4. In this MOSFET structure, n⁺ source and drain junction regions 402 and 403 are formed in a surface of an p⁻ substrate 401, and source and drain electrodes 404 and 405 are formed on these junction regions 402 and 403, respectively. On the surface of the substrate 401 there is formed a gate oxide film 406 and a gate 407 is formed on the gate oxide film 406. The channel is defined by light doped source and drain regions 402a and. The structure so far explained is identical with the ordinary MOSFET structure. In this MOSFET structure, an island region 408 having a high p-type impurity concentration is formed at a center of a channel. This p⁺ island region 408 is formed by an ion implantation from the surface of the substrate after forming the gate 406 from a direction inclined by 45 degrees.

In the MSOFET structure proposed by Y. Momiyama et al, the device property under an operating voltage lower than a threshold voltage is improved by the highly doped island region 408 formed within the channel. To this end, the high doped island region 408 is extended beyond the lightly doped source and drain regions 402a and 403a. Then, a control of the gate could not be performed efficiently. Moreover, Y. Momiyama et al have not discussed the device property under an operating voltage not lower than the threshold voltage.

A similar MOSFET structure has been proposed in JPA 63-241965 published on October 7, 1988 and JPA 6-37309 published on February 10, 1994. In the MOSFET structure proposed in JPA 63-241965, a highly doped island is formed for controlling a threshold voltage. To this end, the highly doped island region is formed within a channel to extend deeply beyond the source and drain junction regions. Furthermore, in the MOSFET structure proposed in JPA 6-37309, a highly doped island region is formed within a channel such that a variation in the threshold voltage is suppressed and a punch-through effect is avoided. To this end, the highly doped island is extended deeply beyond the lightly doped source and drain regions 402a and 403a. Therefore, these known MOSFET structures could not improve the device property sufficiently.

As mentioned above, the performance of the semiconductor device having the MOSFET structure could be no more improved by the miniaturization, and it is expected that the performance of integrated circuits could not be improved in a near feature.

In accordance with the miniaturization of the MOSFET structure, the property of semiconductor devices formed in a same wafer might vary and a reliability of the integrated circuits might be lost.

### Summary of the Invention

Therefore, it is an object of the present invention to provide a semiconductor device having a novel MOSFET structure, in which the performance of the device can be improved and a variation in the device property can be effectively suppressed even if the MOSFET structure is miniaturized.

According to the invention, a semiconductor device with MOSFET structure comprises:
a semiconductor substrate having a substantially uniform impurity concentration of one conductivity type;
a source region and a drain region of a second conductivity type provided in a surface of the substrate to be separated from each other with interposing a channel therebetween, said channel having a first impurity concentration of the first conductivity type;
a source electrode and a drain electrode formed to be connected to said source region and drain region, respectively;
a gate oxide film provided on the surface of the semiconductor substrate;
a gate region provided on the gate oxide film; and
an island region having a second impurity concentration of the first conductivity type which is higher than said first impurity concentration of the channel, said island region being formed at a center of the channel to extend into the semiconductor substrate up to a level substantially identical with a depth of said source and drain regions to constitute a potential barrier.

In the conventional MOSFET structure, the semiconductor substrate has the substantially uniform distribution of impurity concentration or has the retro grade distribution in which the impurity concentration is changed gradually viewed in a direction of a depth.

In the semiconductor device according to the invention, the semiconductor substrate has a substantially uniform impurity concentration, and the island region having a higher impurity concentration is formed at a center of the channel such that a potential barrier is formed within the channel. When an operating voltage is low to make the channel being pinch-off, carriers injected from the source region are stopped by the potential barrier formed by the island region. Therefore, the current property in the channel pinch-off condition can be improved materially. When the operating voltage is increased to make the channel conductive, die carriers are abruptly drawn into the drain region, while the carriers are accelerated along a steep potential slope formed on the side of the drain.

As explained above, according to the invention, when the gate voltage is low, the potential barrier induced by the highly doped island region can effectively prevent a leakage current from being flowed into the drain, and electric current-voltage property can be improved.

On the other hand, when a higher gate voltage is applied, the channel is made conductive and a large electric current flows into the drain region, because the highly doped island produces a steep potential slope on the side of the drain region. Then, the current driving ability with respect to the gate voltage is improved by the highly doped island region as compared with the known MOSFET structure without the highly doped island region under the same channel length and the same operating voltage.

Furthermore, according to the invention, the highly doped island region is extended into a substantially same level as the source and drain regions, a variation in device property between devices formed in a same wafer can be greatly suppressed, and a short channel effect can be effectively prevented.

When the impurity concentration of the semiconductor substrate is too low, a channel resistance might be increased and a parasitic electric current might be flown, it is preferable that an impurity concentration of the substrate, i.e. channel should be not less than 1/100 of an impurity concentration of the high doped island region.

### Brief Description of the Drawings

Fig. 1 is a cross sectional view showing a known MOSFET structure;
Fig. 2 is a cross sectional view illustrating another known MOSFET structure;
Fig. 3 is a cross sectional view depicting a known vertical type MOSFET structure;
Fig. 4 is a cross sectional view illustrating another known MOSFET structure;
Fig. 5 is a cross sectional view showing an embodiment of the MOSFET structure according to the invention;
Fig. 6 is a graph representing a channel potential in the MOSFET structure according to the invention; and
Fig. 7 is a graph expressing a channel potential in the known MOSFET structure.

### Explanation of the Preferred Embodiments

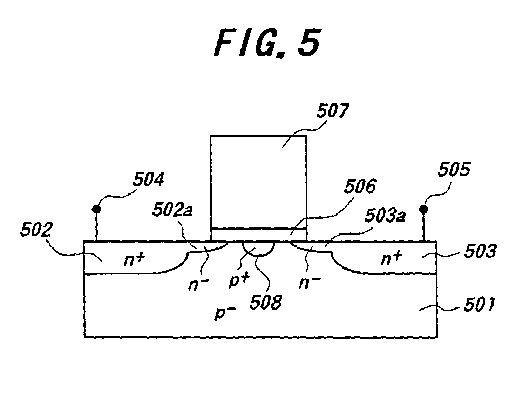

Fig. 5 is a cross sectional view showing an embodiment of the semiconductor device according to the invention. A silicon substrate 501 has a substantially uniform low impurity concentration of 10¹³-10¹⁴ atoms/cm³. In a surface of the substrate 501 there are formed a source junction region 502 and a drain junction region 503, and a source electrode 504 and a drain electrode 505 are formed to be connected to the source junction region 502 and drain junction region 503, respectively. The MOSFET structure of the present embodiment has n⁻ source and drain regions 502a and 503a are formed to be opposed to each other, while a channel is formed between these source and drain regions 502a and 503a. The channel region is formed by the substrate 501, and thus has the low impurity concentration. A gate oxide film 506 is deposited on the silicon substrate 501 and a gate 507 made of a highly doped polysilicon is provided on the gate oxide film 506.

According to the invention, an island region 508 having a high p-type impurity concentration is provided at a center of the channel. An impurity concentration of this island region 508 may be 10¹⁷-10¹⁹ atoms/cm³. Such an island region 508 may be formed by a focused-ion-beam implantation from the vertical direction. It should be noted that in the semiconductor device according to the invention, portions except for the island region 508 are formed in accordance with a same scaling low as the conventional MOSFET structure.

According to the invention, the highly doped island region is extended into the substrate 501 to such a level which is substantially identical with the source and drain regions 502a and 503a. In order to perform the gate control effectively, it is preferable to form a shallow island region. However, such a shallow island region might increase a resistance for carriers. Therefore, according to the invention, the highly doped island region 508 is extended substantially up to the level of the source and drain regions 502a and 503a. By such a structure, a variation in the device property for respective devices can be suppressed effectively, and at the same time, the short channel effect can be also suppressed.

The threshold voltage of the semiconductor device according to the invention is mainly determined by a peak value and a spread of the impurity concentration of the highly doped island region 508. In this case, since a spread of the impurity concentration is determined by a process for forming the highly doped region 508, a peak value of the impurity concentration of the highly doped region 508 is suitably set to attain a desired threshold voltage.

In contrast to this, a contribution of the uniformly distributed impurity concentration of the substrate 501 to the device property is small. However, when the impurity concentration of the substrate 501 is set to a too low value, a channel resistance is increased and a parasitic current might flow. Therefore, according to the invention, the impurity concentration of the substrate 501 is preferably set to a value not less than 1/100 of the impurity concentration of the highly doped island 508.

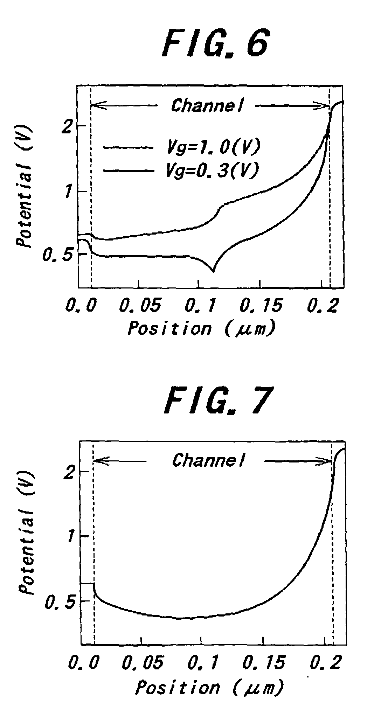

According to the invention, the highly doped island region formed at a center of the channel produces a potential barrier within the channel. Fig. 6 is a graph representing a simulation result of the potential distribution within the channel in the MOSFET according to the invention. In this graph, a solid line denotes the potential distribution when a gate voltage Vg is set to 0.3 V, in which the channel is pinched-off and no current flows, and a broken line expresses the potential distribution when Vg is set to 1.0 V and the channel is made conductive under a condition that a drain voltage is kept constant. In the pinch-off state, the potential barrier is formed at a center of the channel, but when the current flows, the potential barrier is changed into a steep slope.

For the sake of comparison, a potential distribution of the known MOSFET structure without the highly doped island region is shown in Fig. 7. As explained above, in the semiconductor device according to the invention, the MOSFET structure can be effectively improved by providing the highly doped island region within the channel such that the island region is extended to a level substantially identical with the source and drain regions and the impurity concentration of the channel, i.e. substrate is not lower than 1/100 of the impurity concentration of the highly doped island region. Particularly, the performance of the semiconductor device can be improved and a variation in device property can be effectively suppressed. Therefore, the property of integrated circuits can be further improved and a cost of the integrated circuits can be further reduced by the miniaturization.

## Claims

1. A semiconductor device with MOSFET structure comprising:
a semiconductor substrate having a substantially uniform impurity concentration of one conductivity type;
a source region and a drain region of a second conductivity type provided in a surface of the substrate to be separated from each other with interposing a channel therebetween, said channel having a first impurity concentration of the first conductivity type;
a source electrode and a drain electrode formed to be connected to said source region and drain region, respectively;
a gate oxide film provided on the surface of the semiconductor substrate;
a gate region provided on the gate oxide film; and
a highly doped island region having a second impurity concentration of the first conductivity type which is higher than said first impurity concentration of the channel, said highly doped island region being formed at a center of the channel to extend into the semiconductor substrate up to a level substantially identical with a depth of said source and drain regions to constitute a potential barrier.

2. A semiconductor device as claimed in Claim 1, wherein the impurity concentration of the substrate is not lower than 1/100 of the impurity concentration of the highly doped island region.

3. A semiconductor device as claimed in claim 1, wherein said source region is formed by a highly doped source junction region and a lower shallow doped source region, said drain region is formed by a highly doped drain junction region and a lower shallow doped drain region, said source electrode and drain electrode are formed on the highly doped source and drain junction regions, respectively, and said highly doped island region is extended to a substantially same level of the shallow doped source and drain regions.
